# EUROPEAN PATENT APPLICATION

(11) **EP 4 459 675 A1**
(43) Date of publication of application: **06.11.2024**
(21) Application number: 23171465.0
(22) Date of filing: 04.05.2023
(51) Int. Cl.: H01L 23/495, H01L 23/31

(54) **A METHOD OF IMPROVING PACKAGE CREEPAGE DISTANCE**

(71) Applicant: Nexperia B.V., 6534 AB Nijmegen (NL)
(72) Inventor: Funke, Hans-Juergen, Hamburg (DE); Shiu, Heiming, Hamburg (DE); Böttcher, Tim, Hamburg (DE)
(74) Representative: Pjanovic, Ilija

(57) **Abstract**

The present disclosure relates to a method of improving semiconductor package creepage, wherein the package comprises a semiconductor device, and a plurality of electrically conductive contacts at a surface of the package, the package comprising insulating material for electrically insulating the package between the plurality of electrically conductive contacts, wherein an initial creepage distance is defined by the shortest distance over the surface of the package between two of the plurality of contacts, and the method comprising the steps of applying a coating over at least part of said insulating material of said package, wherein said coating has an electrical volume resistivity higher than an electrical volume resistivity of said insulating material of said package to increase the initial creepage distance and improve package creepage of the semiconductor package.

## Description

### Technical field

The present disclosure is directed to a method improving package creepage distance for an integrated circuit package, in particular for high voltage devices.

### Background

Creepage and clearance are typical industry standard critical properties for packages of discrete semiconductors and Integrated Circuits, ICs.

Clearance may be defined as the shortest distance in air between two conductors. Hence, as the shortest distance is through air, it can be understood as, or comparable to the line of sight between to peaks, i.e. given no obstacles between two conductors, it is the shortest distance between the conductors.

Creepage is closely related to clearance however and may be defined as the shortest distance between two conductors along the surface of the insulating material. Hence, in comparison with the example of clearance, instead of the shortest distance over air, the shortest distance over land between the two peaks.

Especially for high voltage devices the creepage and also clearance are very important, and with the trend in increase in voltages of the devices, which may even exceed 500V, and trend of miniaturization of semiconductor device packages, creepage and clearance becomes even more important.

Insufficient creepage may result in voltage breakdown in which the voltage between two conductors overcomes the insulation in between the conductors and may create an arc or conductive path across the surface of the insulating material which can damage the device, cause failure of the operation of the device and may cause hazardous situations.

Creepage properties can be improved by increasing the distance between the two conductors. Typically, that will increase the package size, which is contrary to the desire for miniaturization. Alternatively, creepage properties may be improved by adding plastics over exposed conductive parts of the package. This however requires additional measure to be taken in the assembling of the end user device. Yet another alternative to improve creepage properties is the use of leadframes package designs, which however result in reduction of heatsink size, which in turn has decreases thermal properties of the package.

### Summary

It is an object of the present disclosure, to provide for a method of improving creepage properties for semiconductor package, especially for high voltage applications, which does not result in increase of spacing between conductors of the package, and wherein disadvantages related to known creepage property improving methods are resolved.

In a first aspect, there is provided a method of improving semiconductor package creepage, wherein the package comprises a semiconductor device, and a plurality of electrically conductive contacts at a surface of the package, the package comprising insulating material for electrically insulating the package between the plurality of electrically conductive contacts, wherein an initial creepage distance is defined by the shortest distance over the surface of the package between two of the plurality of contacts, and the method comprising the steps of:
- applying a coating over at least part of said insulating material of said package, wherein said coating has an electrical volume resistivity higher than an electrical volume resistivity of said insulating material of said package to increase the initial creepage distance and improve package creepage of the semiconductor package.

Safety and reliability are two important measures in the design and use of semiconductor devices, especially for high voltage applications. In general these measures may relate to the packages which house the semiconductor devices, and to the Printed Circuit Boards, PCB, on which the semiconductor packages or devices are mounted (e.g. soldered).

Creepage and clearance are two typical properties for both the PCB and the packages which have a high impact on the reliability and the safety. As such, certain applications, environments and/or designed maximum operating voltage levels may require certain levels of creepage and clearance.

Certain commonly used semiconductor packages have standard pin-to-pin clearance and creepage distances. Newer versions of the same package standard may further increase pin-to-pin clearance to improve safety and reliability and/or to set higher maximum voltage levels.

Further improvement is challenging as it may require complex modification to the package, for example by introducing grooves, notches or slots into the package to increase the path between two conductors and thereby improve creepage properties of the package.

High voltage applications are typical application in which creepage is a critical property of the package. Typically, the packages for such applications, as for example a TO220 style package, have two or three leads and a metal tab like surface which may allow mounting to an external heatsink and functions as a heatsink to allow the device to dissipate heat.

Improving creepage distance by modification of such packages may have an impact on the heat dissipation capabilities of the device, which especially for high voltage packages and thus high power applications may be a problem.

It was the insight of the inventors that improvement of the creepage properties, by increasing the creepage distance, can be achieved by coating parts of the package with a specific coating material having improved insulating properties. Certain materials may have such improved insulating properties which, when applied in thin layers over all or part of the insulating material of the package, hence the surface of the package which is not defined as the electrical contacts, will increase the electrical resistance of the package. The increase will result in improved electrical resistance and thus an in improvement of the package creepage which is achieved by selecting an insulating material as coating which has an electrical volume resistivity lower than the electrical volume resistivity of the insulating material of said package. Hence, this will result in an increase of the initial creepage distance and improve package creepage of the semiconductor package.

An measure for (organic) materials like moulding compounds to prevent failure from voltage breakdown is comparative tracking index (CTI). CTI may be considered a standard, used to measure the resistance of a material to surface tracking caused by electrical leakage. Surface tracking occurs when a conductive path is formed on the surface of a material, which can cause a short circuit or electrical breakdown. The CTI value may be determined by exposing a sample of the material to a high voltage (typically 600 volts) and tracking the number of seconds it takes for a conductive path to form on the surface of the material. The time taken for the conductive path to form is compared to that of other materials tested under the same conditions. The higher the CTI value, the more resistant the material is to surface tracking. The CTI is expressed in units of volts and is a measure of the voltage level at which a material will track when compared to other materials. The higher the CTI value, the higher the voltage that can be applied to the material before it starts to track.

The CTI value is important in selecting materials for electrical and electronic applications, particularly in determining the safety and reliability of electrical insulation materials. A higher CTI value indicates that the material is less likely to cause electrical problems, and is therefore more suitable for use in high-voltage applications.

Non-organic insulators as glass or ceramics have the property that they will not track and thus have a high CTI value, as no conductive paths under high voltage conditions will be formed. What is proposed, is to apply a coating of the insulating material of the package, i.e. the plastic surface of the semiconductor package, with a thin layer of inorganic coating material to overcome the tracking issue. Hence, to coat the package or at least its plastic surface areas with a material having a high CTI value. The coating thus is categorized preferably in material group I or II, more preferably in group I, having a CTI index of at least 400, more preferably at least 500, even more preferably at least 600 VAC, or most preferably, a unlimited CTI index such as glass or ceramics, or any other suitable inorganic coating material which can be applied in semiconductor packaging processes and which do not breakdown on the surface.

In an example, the electrical volume resistivity of said coating is in the range of 1 x 10¹⁶ to 1 x 10¹⁸ Ω-cm, more preferably in the range of 5 x 10¹⁶ to 5 x 10¹⁷ Ω-cm and most preferably in the range of 8 x 10¹⁶ to 2 x 10¹⁷ Ω-cm.

In an example, the coating has an increased thermal resistance of a factor 3 or less, and more preferably a factor 2 or less, as compared to said electrically conductive contacts of said package.

In an example, the coating comprises a layer of insulating material selected from one of the group of: Al2O3/TiO2, parylene, polyimide or other polymer materials as used for conformal coating of PCBs in electronic equipment.

In an example, the coating comprises a layer of insulating material is applied with a thickness of less than 100µm, more preferably less than 10 µm, most preferably less than 1 µm.

In an example, the coating comprises a layer of insulating material which is applied by Atomic Layer Deposition, ALD.

In an example, the coating comprises a layer of insulating material which is applied by a deposition method, preferably a vacuum deposition method, and more preferably a chemical vapor deposition method.

In an example, the coating comprises a layer of insulating material which is applied by sputtering.

In an example, the coating comprises a layer of insulating material which is applied by spraying.

In an example, the coating comprises a layer of insulating material which is further applied to a part of at least one of said plurality of electrically conductive contacts of said package.

In an example, the coating comprises a layer of insulating material which is further applied to all of said plurality of electrically conductive contacts of said package.

In an example, the coating comprises a layer of insulating material which is applied over all of said insulating material of said package.

In an example, the coating comprises a layer of insulating material which is further applied to a heatsink of said package.

In an example, the device is a discrete Surface-Mounted Device, SMD, semiconductor device or a discrete Thin High Phosphorus, THP, semiconductor device.

In a second aspect, there is provided a semiconductor package having a coating applied over at least part of said insulating material of said package, wherein said coating has an electrical volume resistivity higher than an electrical volume resistivity of said insulating material of said package to increase the initial creepage distance and improve package creepage of the semiconductor package, and wherein the application of said coating is performed in accordance with the first aspect of the present disclosure.

The definitions and advantages of the first aspect of the present disclosure are also applicable to any of the other aspects of the present disclosure.

The above and other aspects of the disclosure will be apparent from and elucidated with reference to the examples described hereinafter.

### Brief description of the drawings

Fig. 1a and 1b disclose a semiconductor package;
Fig. 2 discloses the steps of a method of improving semiconductor package creepage in accordance with a first aspect of the present disclosure;
Fig. 3 discloses a semiconductor package with improved creepage properties according to a first embodiment;
Fig. 4 discloses a semiconductor package with improved creepage properties according to a second embodiment;
Fig. 5 discloses a semiconductor package with improved creepage properties according to a third embodiment;
Fig. 6 discloses a semiconductor package with improved creepage properties according to a second embodiment.

### Detailed Description

It is noted that in the description of the figures, same reference numerals refer to the same or similar components performing a same or essentially similar function.

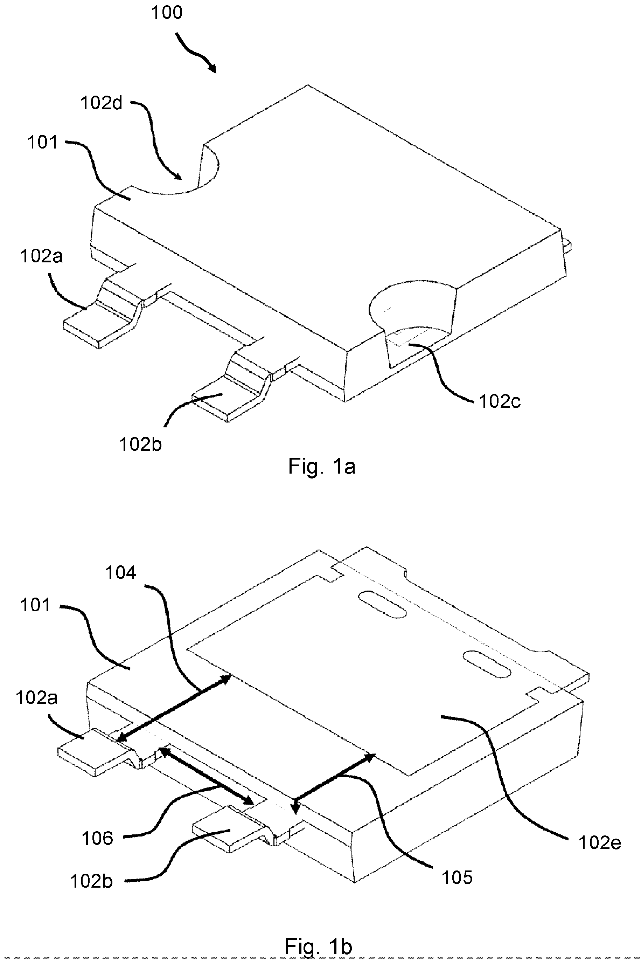

Fig. 1a and 1b disclose a typical semiconductor package 100 comprising discrete semiconductor components or Integrated Circuit(s), IC(s).

The semiconductor package 100 comprises the semiconductor device, and a plurality of electrically conductive contacts 102a, 102b, 102c, 102d, 102e at a surface of the package. These contacts are conductive and exposed, as can been seen in Fig. 1a and 1b. The package 100 shown here by way of example, has two leadframes or leadframe strips, or simply leads 102a, 102b. The example shown in Fig. 1a, 1b also has two notches 102c, 102d, which are used for molding the package and a heatsink 102e or contact surface for fixing the package 100 onto an external heatsink (not shown). The semiconductor package further comprises insulating material 101 for electrically insulating the package 100 between the plurality of electrically conductive contacts 102a-e.

Creepage is a typical industry standard critical property for packages of discrete semiconductors and Integrated Circuits, ICs. Creepage may be defined as the shortest distance between two conductors along the surface of the insulating material. When looking at Fig. 1b, there are two types of creepage, the creepage distance on the PCB 104, which may also be defined as the clearance as the shortest distance through air between two electrically conductive surfaces of the package, and creepage distance on the package 105, which is the shortest distance over the surface of the package between two electrically conductive surfaces of the package. The proposed method to improve creepage properties, may improve one but preferably both of the creepage distance on the PCB 104 and the creepage distance on the package 105.

In Fig. 1a, 1b the creepage 104, 105, 106 prior to the method according to the present disclosure, is defined as the initial creepage distance. Which is thus the shortest distance between two of a plurality of contacts of the package, in the example shown in Fig 1b, the distance 104 between 102a and 102e, and/or the distance 105 between 102b and 102e and the distance 106 between 102a and 102b. When the method is performed, the package creepage of the semiconductor package is improved, without having to modify the package design, materials or processing of the package.

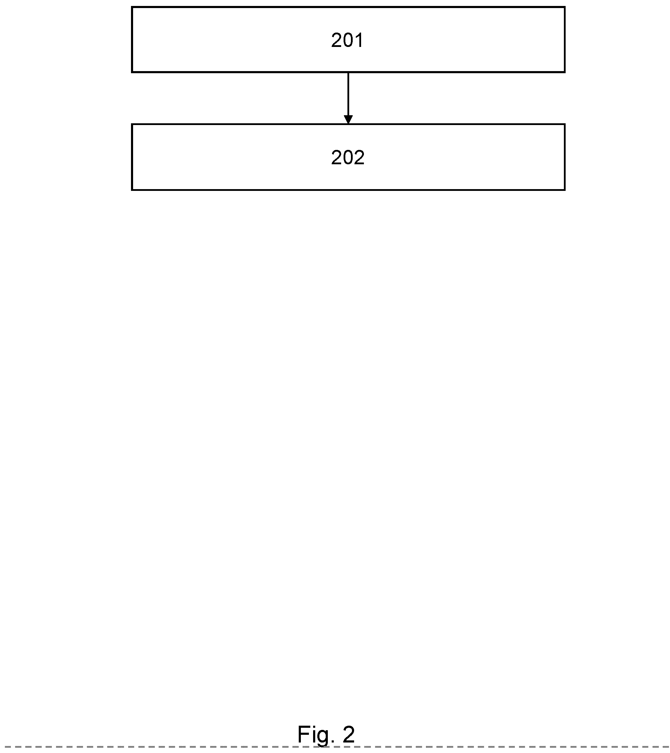

Fig. 2 discloses the basic steps 201, 202 of a method of improving semiconductor package creepage. The semiconductor package comprises a semiconductor device, and a plurality of electrically conductive contacts at a surface of the package. The semiconductor package further comprises insulating material for electrically insulating the package between the plurality of electrically conductive contacts.

In step 201 a semiconductor package is provided. The semiconductor package comprises discrete semiconductors and/or integrated circuits. The initial creepage distance is defined by the shortest distance over the surface of the package between two of the plurality of contacts. The package comprises a plurality of electrically conductive contacts at a surface of the package, and comprises insulating material for electrically insulating the package between the plurality of electrically conductive contacts. The package, without performing the method according to the present disclosure, has an initial creepage distance.

In step 202 a coating is applied over at least part of said insulating material of said semiconductor package. Hence, the package has electrical contacts, being the heatsink 102e of the package, the leadframe strips 102a, 102b, dam bar area, or any other exposed conductive, e.g. metal, parts of the package such as the mould notches 102c, 102d. The coating is thus applied to at least one of the insulating areas or also referred to as the package or plastic areas of the package, and may preferably also be applied to the exposed conductive areas of the package. The coating may cover part or all of the exposed area of the plastic and preferably part or all of the conductive areas. The coating has an electrical volume resistivity higher than an electrical volume resistivity of the insulating material, hence the plastic of the package. This way the initial creepage is improved and thereby the package creepage of the semiconductor package is improved as well. This is even further improved when also part or all of the exposed conductive areas is covered by the coating.

The coating is applied in accordance with step 202 in a thin layer, e.g. less than 100µm, more preferably less than 10 µm, most preferably less than 1 µm, and may comprise one or more of Al2O3/TiO2, parylene, polyimide or other polymer materials as used for conformal coating of PCBs in electronic equipment.

Applying any layer of insulating material over the package and preferably over exposed electrically conducting area, either fully covering the area or partly covering it, will lower electrical conductivity, however, the coating is applied in such a way, that the thermal conductivity, due to the layer thickness, is decreased to a lesser degree than the degree in electrical conductivity. This can be achieved through application of various materials in a thin layer, and to such an extent that a package thermal resistance increase is less than a factor 3, or preferably to a factor 2, when compared to an uncoated semiconductor package. Accordingly, the initial creepage is increased and the overall package creepage of the semiconductor package is improved.

With the method according to the present disclosure, the package creepage is improved, and only when the conductive areas are coated as well, the thermal resistance is increased to a limited extent, e.g. with a maximum of a factor 3 or 2 of the initial thermal resistance of the package, such a package on the one hand meets minimum creepage distance of electrical conductors as described e.g., in IEC60664-1 and IPC2221A, whereas on the other hand, the thermal resistance is still within prescribed range to meet packaging requirements. Hence, the thermal path for the package for cooling is electrically isolated, to such a degree that the creepage properties are improved but with minimal, and at least within specification, reduction in thermal conductivity.

The coating may be applied in full, or partially, on part of the package and preferably on one of the exposed electrical contacts, or on several or all of the electrical contacts such as on the heatsink. The coating can be applied in addition or alternatively also at the leads (e.g., at area of dambar remains) close to package or on top of the exposed metal parts of mould notch.

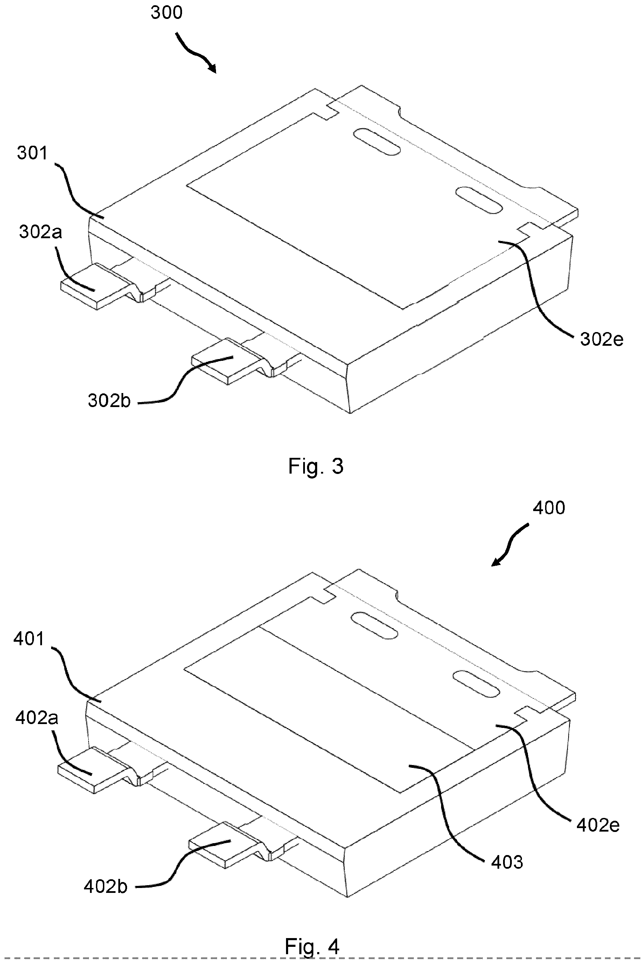

In Fig. 3, 4, 5 and 6 four different examples 300, 400, 500, 600 are shown of a package on which the method of the present disclosure is applied. In order to reduce the required creepage distances according to insulation coordination for electrical equipment, plastic area of the package are according to the present disclosure partially or fully coated by a material like an ALD layer, parylene or other insulating coating materials like conformal coating materials. The coating material has a CTI value according to material group 1 (refer IEC60664-1) to minimize the required distances of metal parts of the package. ALD coating materials like Al2O3/TiO2 will not track at all.

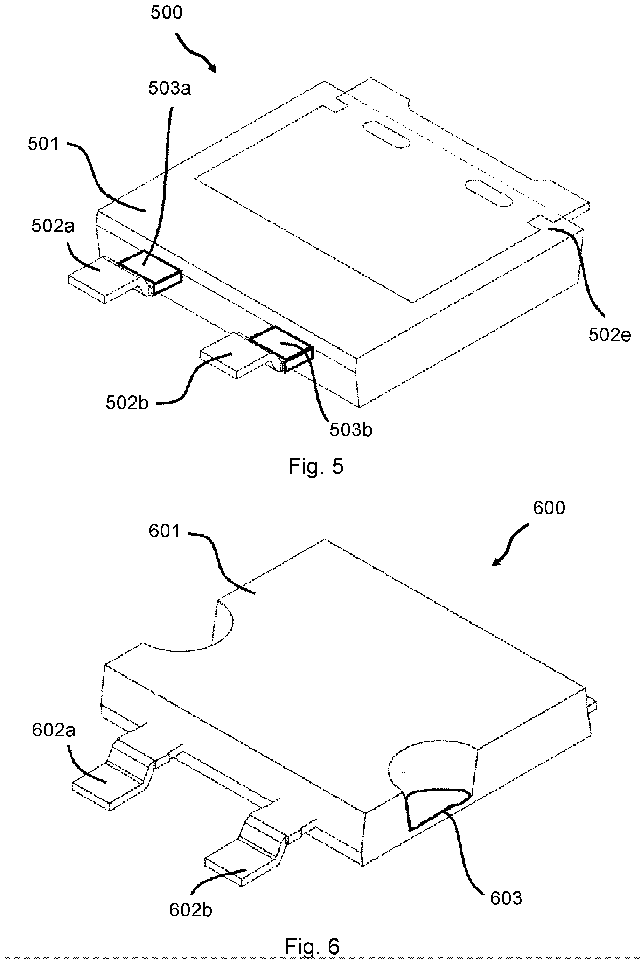

There are several different example to apply a coating according to the present disclosure on a package:
a) Partly coating the insulating material of the package (not shown), at least between two electrical contacts.
b) Fully coating the insulating material of for example an SMD package as shown in Fig. 3. Hence, all of the (plastic) package is covered, as shown in Fig. 3, wherein the packages insulating material 301 is comprised of a coating according to the present disclosure.
c) In addition to b), also partially coating 403 the heatsink 402e of the SMD package 400 to increase the creepage distance between heatsink 402e and leads 402a, 402b, as shown in Fig. 4;
d) In addition to b), also coating 503a, 503b of the leads 502a, 502b, and part of plastic body 501 at which the leads enter the plastic body (e.g., at dam bar area) to increase the creepage distance between the leads as shown in Fig. 5;
e) In addition to b), also coating 603 of the exposed metal parts of a mould notch to avoid exposed metal parts with high voltage potential as shown in Fig. 6.

The coating material as applied to metal parts of plastic body of the packages comprise a material such as Al2O3/TiO2 applied by ALD (atomic layer deposition), parylene, polyimide or other polymer materials as used for conformal coating of PCBs in electronic equipment. The skilled person will appreciate how such coatings are applied, which process is thus not further described in the present disclosure, as application on semiconductor packages is done in the same way.

Fig. 4 shown another example of a partial coating 403 of the heatsink 403e of a SMD package 401 to increase the creepage distance of the leads. The way of processing and coating position in the assembly flow will be as described under b).

The assembly process of the semiconductor package will be done in usual way including moulding of the leadframe strips. Individual packages have been built and will still be on leadframe strips. Prior to galvanic tin plating the plastic bodies of the packages will be coated with one of the above-mentioned materials. Coverage of the parts of packages and metal parts (e.g., heatsink and leads) at which the coating should be not applied needs to be done prior to coating process. Alternatively, the coating can be done without masking and the coating can be removed on metal parts by electrolytic deflash as used to remove mould compound residues on metal parts after moulding. Alternatively, laser or light ablation could be used to remove the coating on metal parts.

After coating and in case needed after removing the coating on metal parts the ongoing processing of the leadframe strips can be done in usual way.

As an alternative the coating of the plastic bodies can be done on the moulded leadframe strips after galvanic tin plating.
As an alternative the coating of the plastic bodies can be done on the moulded leadframe strips after galvanic tin plating and singulation in individual packages. In Fig. 4 another example 400 is shown of coating a package 401, in which a full coverage 403 of the plastic package is applied. The way of processing and coating position in the assembly flow is already described in view of Fig. 3. Keeping areas of heatsink free from coating can be done as well as described in relation to the example of Fig. 3. As result the uncoated part of the heatsink will remain electrically conductive and as well the thermal conductivity will be not impacted at this uncoated area. The advantage of this method is to increase the creepage distance towards other metal conductors (e.g., package leads) after soldering on PCB in customer application.

Fig. 5 shows yet another example of additionally coating the leads and preferably part of plastic body at which the leads enter the plastic body (e.g., at dam bar area) to increase the creepage distance between the leads. The way of processing and the assembly flow can be done as described in reference to Fig. 3, but coating is preferably done after leadframe dam bar cut. Keeping areas of metal parts (leads and heatsink) free from coating can be done as described in reference to Fig. 3. For this option the area of leads close to plastic body will be coated.
This problem can be solved by the embodiment shown in Fig. 5. Due to punching operation for removing the dam bars there will be always some remains which reduce the clearance from lead to lead. The coating will isolate the dam bar remains and air to air clearance distance of uninsulated metal parts is not applicable anymore.

Fig. 6 shows yet another example of additionally coating 603 of the exposed metal parts of mould lock or mould notch features 102c, 102d, to avoid exposed metal parts with high voltage potential.
This embodiment solves that exposed metal parts at the package at which some mould tool feature press down the die pad to bottom mould to avoid plastic resin coverage on the heatsink (exposed Cu parts on back heatsink/packages). At this location the Cu of the die pad will remain exposed and is connected to electrical potential. Coating of the metal parts at this area will be used to isolate these areas and will help to increase creepage distances in final application.

In any of the examples described, ALD may be used to apply Al2O3/TiO2 or parylene in very thin layers. Especially for ALD the coating layer can be in sub µm thickness. This minimizes the impact of the thermal conductivity from package heatsink to external heatsink by maintaining electrical isolation. Also, partially coverage of package metal parts is possible by the proposed method. No modification on package design, materials or processing is necessary. The proposed method allows to select mould compounds with optimal properties for e.g., adhesion (zero delamination) and best thermo-mechanical performance with more freedom on creepage related properties (material class), without requiring additional steps after manufacturing. E.g. conformal coating of complete assembled PCB can be skipped. As such, a flexible increase of high voltage creepage distances of semiconductor plastic packages may be achieved by partial or full conformal coating of metal parts. The proposed method may be applied on a large variety of packages and for various applications, amongst which:
- Discrete Packages and Modules for SiC devices
- SMD discrete semiconductor components
- THP discrete semiconductor components
- Electronic passive components
- Modules
- System in packages (SIP)
- etc.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

### LIST OF ELEMENTS IN THE DRAWINGS

- 100: semiconductor device
- 101: insulating material
- 102a: first lead
- 102b: second lead
- 102c: first mould notch
- 102d: second mould notch
- 102e: heatsink
- 104: creepage distance
- 105: creepage distance
- 106: creepage distance
- 201: first step of the method
- 202: second step of the method
- 300: semiconductor device according to first embodiment
- 301: insulating material
- 302a: first lead
- 302b: second lead
- 302e: uncoated heatsink section
- 303: partly coated heatsink
- 400: semiconductor device according to second embodiment
- 401: insulating material
- 402a: first lead
- 402b: second lead
- 403: fully coated heatsink
- 500: semiconductor device according to third embodiment
- 501: insulating material
- 502a: first lead
- 502b: second lead
- 503a: partly coated first lead
- 503b: partly coated second lead
- 502e: heatsink
- 600: semiconductor device according to fourth embodiment
- 601: insulating material
- 603: fully coated first mould notch
- 602a: first lead
- 602b: second lead

## Claims

1. A method of improving semiconductor package creepage, wherein the package comprises a semiconductor device, and a plurality of electrically conductive contacts at a surface of the package, the package comprising insulating material for electrically insulating the package between the plurality of electrically conductive contacts, wherein an initial creepage distance is defined by the shortest distance over the surface of the package between two of the plurality of contacts, and the method comprising the steps of:
- applying a coating over at least part of said insulating material of said package, wherein said coating has an electrical volume resistivity higher than an electrical volume resistivity of said insulating material of said package to increase the initial creepage distance and improve package creepage of the semiconductor package.

2. The method of improving semiconductor package creepage according to claim 1, wherein said electrical volume resistivity of said coating is in the range of 1 x 10¹⁶ to 1 x 10¹⁸ Ω-cm, more preferably in the range of 5 x 10¹⁶ to 5 x 10¹⁷ Ω-cm and most preferably in the range of 8 x 10¹⁶ to 2 x 10¹⁷ Ω-cm.

3. The method of improving semiconductor package creepage according to any of the previous claims, wherein said coating has an increased thermal resistance of a factor 3 or less, and more preferably a factor 2 or less, as compared to said electrically conductive contacts of said package.

4. The method of improving semiconductor package creepage according to any of the claims, wherein the coating comprises a layer of insulating material selected from one of the group of: Al2O3/TiO2, parylene, polyimide or other polymer materials as used for conformal coating of PCBs in electronic equipment.

5. The method of improving semiconductor package creepage according to any of the claims, wherein the coating comprises a layer of insulating material is applied with a thickness of less than 100µm, more preferably less than 10 µm, most preferably less than 1 µm.

6. The method of improving semiconductor package creepage according to any of the claims, wherein the coating comprises a layer of insulating material which is applied by Atomic Layer Deposition, ALD.

7. The method of improving semiconductor package creepage according to any of the claims, wherein coating comprises a layer of insulating material which is applied by a deposition method, preferably a vacuum deposition method, and more preferably a chemical vapor deposition method.

8. The method of improving semiconductor package creepage according to any of the claims, wherein the coating comprises a layer of insulating material which is applied by sputtering.

9. The method of improving semiconductor package creepage according to any of the claims, wherein the coating comprises a layer of insulating material which is applied by spraying.

10. The method of improving semiconductor package creepage according to any of the claims, wherein the coating comprises a layer of insulating material which is further applied to a part of at least one of said plurality of electrically conductive contacts of said package.

11. The method of improving semiconductor package creepage according to any of the claims, wherein the coating comprises a layer of insulating material which is further applied to all of said plurality of electrically conductive contacts of said package.

12. The method of improving semiconductor package creepage according to any of the claims, wherein the coating comprises a layer of insulating material which is applied over all of said insulating material of said package.

13. The method of improving semiconductor package creepage according to any of the claims, wherein the coating comprises a layer of insulating material which is further applied to a heatsink of said package.

14. The method of improving semiconductor package creepage according to any of the claims, wherein the device is a discrete Surface-Mounted Device, SMD, semiconductor device or a discrete Through Hole Package, THP, semiconductor device.

15. A semiconductor package having a coating applied over at least part of said insulating material of said package, wherein said coating has an electrical volume resistivity higher than an electrical volume resistivity of said insulating material of said package to increase the initial creepage distance and improve package creepage of the semiconductor package, and wherein the application of said coating is performed in accordance with any of the previous claims 1-14.
